# EUROPÄISCHE PATENTSCHRIFT

(11) **EP 1 950 534 B1**
(45) Veröffentlichungstag und Bekanntmachung des Hinweises auf die Patenterteilung: **01.04.2009**
(21) Anmeldenummer: 08150358.3
(22) Anmeldetag: 17.01.2008
(51) Int. Cl.: G01D 11/30, G01R 1/04, H02B 1/52, H05K 7/14

(54) **Fixiereinrichtung für einen Stromsensor**
Fixing device for a power sensor
Dispositif de fixation pour un capteur de courant

(30) Priorität: 24.01.2007 DE 102007004534; 04.05.2007 EP 07107491
(43) Veröffentlichungstag der Anmeldung: 30.07.2008
(73) Patentinhaber: ABB Schweiz AG, 5400 Baden (CH)
(72) Erfinder: Rees, Jochen, D-79761, Waldshut-Tiengen (DE); Halavart, Nuerten, CH-8049, Zürich (CH)
(74) Vertreter: ABB Patent Attorneys

(56) Entgegenhaltungen:
- FR-A- 2 863 363
- US-B1- 6 637 564
- ANONYMOUS: "Rahmenprofile und Zubehör"[Online] 1. Dezember 2005 (2005-12-01), Seite 10.4/6, XP002477628 Gefunden im Internet: URL:http://www.schneider-electric.de/uploa d/FileManager/cat/pdf/pcp/zxktss/ZXKTSS_Ka pitel10_04.pdf> [gefunden am 2008-04-21]

## Beschreibung

### Technisches Gebiet

Die Erfindung bezieht sich auf das Gebiet der Befestigungstechnik. Sie geht aus von einer Fixiereinrichtung für einen Stromsensor gemäss dem Oberbegriff des unabhängigen Anspruchs.

### Stand der Technik

Stromsensoren werden heute in vielen Anwendungen, vor allem in leistungselektronischen Schaltungen, wie beispielsweise Antriebsumrichter, Traktionsumrichter uvm., eingesetzt. Der Stromsensor ist normalerweise mit der entsprechenden Schaltung in einem Schaltschrank eingebaut. Zur Befestigung des Stromsensors im Schaltschrank wird dieser beispielsweise im Schaltschrank mittels Verschraubungen fixiert. Bei typischerweise mehreren Stromsensoren werden diese einzeln im Schaltschrank fixiert. Die Messkabel der einzelnen Stromsensoren müssen dabei jeweils separat geführt und ebenfalls im Schaltschrank befestigt werden. Ferner müssen auch die Kabel mit den zu messenden Strömen jeweils zu den einzelnen Stromsensoren zugeführt werden und ebenfalls im Schaltschrank fixiert werden. Oftmals sind die Platzverhältnisse im Schaltschrank sehr eingeschränkt, wodurch sich die Montage weiter erschwert. Die Montage des bzw. der Stromsensoren ist damit insgesamt sehr kompliziert, durch die Vielzahl der einzelnen Fixierungen fehleranfällig für das Montage- und Wartungspersonal und zudem zeitaufwendig.

In der DE 600 21 565 T2 sowie in der US 4,059,328 ist jeweils eine gattungsgemässe Fixiereinrichtung angegeben.

### Darstellung der Erfindung

Aufgabe der Erfindung ist es deshalb, eine Fixiereinrichtung für einen Stromsensor anzugeben, mittels welcher die Montage vereinfacht, schneller durchgeführt und weniger fehleranfällig ausgeführt werden kann. Diese Aufgabe wird durch die Merkmale des unabhängigen Anspruchs gelöst. In den abhängigen Ansprüchen sind vorteilhafte Weiterbildungen der Erfindung angegeben.

Die erfindungsgemässe Fixiereinrichtung für einen Stromsensor umfasst ein nach Art eines U geformtes Aufnahmeelement und ein mit dem freien Ende eines Schenkels des Aufnahmeelementes verbundenes Flächenteil, wobei das Flächenteil im wesentlichen senkrecht zum verbundenen Schenkel angeordnet ist und sich von der Öffnung des Aufnahmeelementes weg erstreckt. Weiterhin umfasst die Fixiereinrichtung ein mit dem Flächenteil verbundenes und nach Art eines C geformtes Halteelement, wobei die Ausrichtung der Öffnung des Halteelementes im wesentlichen der Ausrichtung der Öffnung des Aufnahmeelementes entspricht. Mit Vorteil lässt sich der Stromsensor sehr einfach zwischen die beiden Schenkel des u-förmigen Aufnahmeelementes einbringen und danach beispielsweise durch Verschraubung fixieren. Dadurch ist eine vorteilhafte Vormontage des Stromsensors oder mehrerer Stromsensoren an der Fixiereinrichtung ausserhalb des endgültigen Einbaus und somit beispielsweise ausserhalb von typischerweise beengten Platzverhältnissen innerhalb eines Schaltschrankes möglich. Nach der Vormontage muss die Fixiereinrichtung lediglich endmontiert werden, beispielsweise in besagtem Schaltschrank. In das mit dem Flächenteil verbundene c-förmige Halteelement kann mit Vorteil eine Kabelhalteeinrichtung eingeschoben und beispielsweise sehr einfach an der Basis des c-förmigen Halteelementes durch Klemmung mittels einer Verschraubung fixiert werden. Kabel mit den mittels der oder den Stromsensoren zu messenden Strömen sind dann lediglich noch an der Kabelhalteeinrichtung zu befestigen und zu dem oder zu den dann nahe gelegenen Stromsensoren zu führen. Insgesamt kann die Montage des bzw. der Stromsensoren damit vereinfacht werden, da eine Vielzahl von einzelnen Fixierungen entfällt. Die Montage kann ferner schneller und mit einer geringeren Fehleranfälligkeit ausgeführt werden.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

### Kurze Beschreibung der Zeichnungen

### Es zeigen:

- Fig. 1: eine Ausführungsform einer erfindungsgemässen Fixiereinrichtung für einen Stromsensor in einer Vorderansicht,
- Fig. 2: die Ausführungsform der erfindungsgemässen Fixiereinrichtung nach Fig. 1 in einer räumlichen Ansicht und
- Fig. 3: Schaltschrankeinbau der erfindungsgemässen Fixiereinrichtung.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

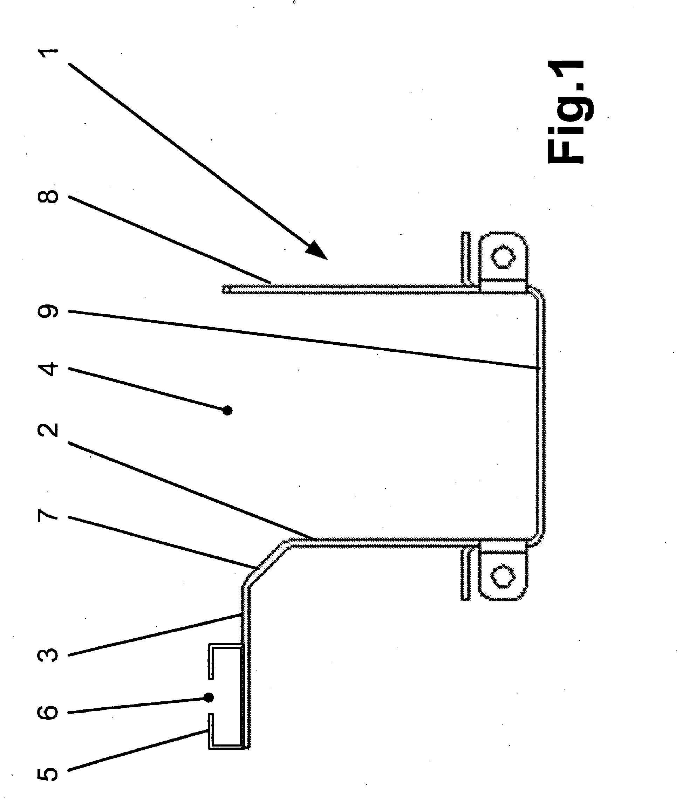

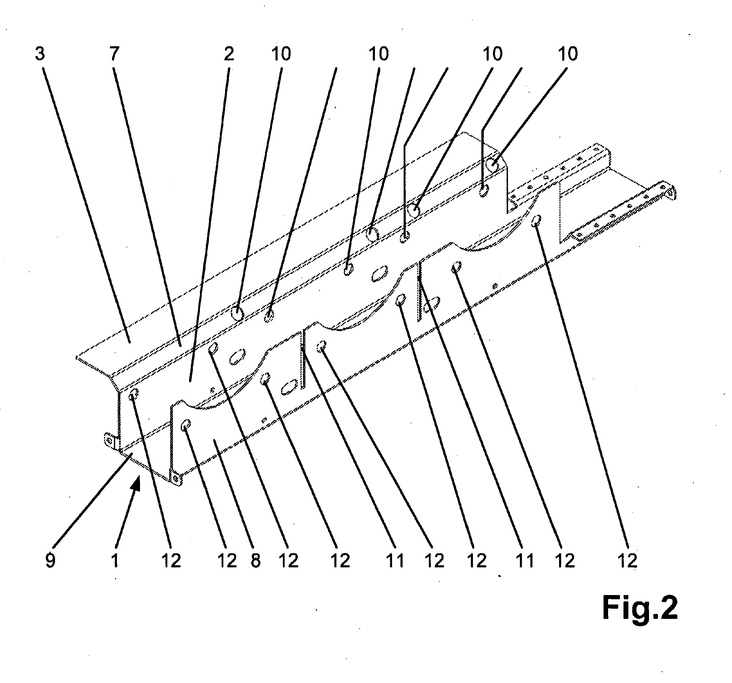

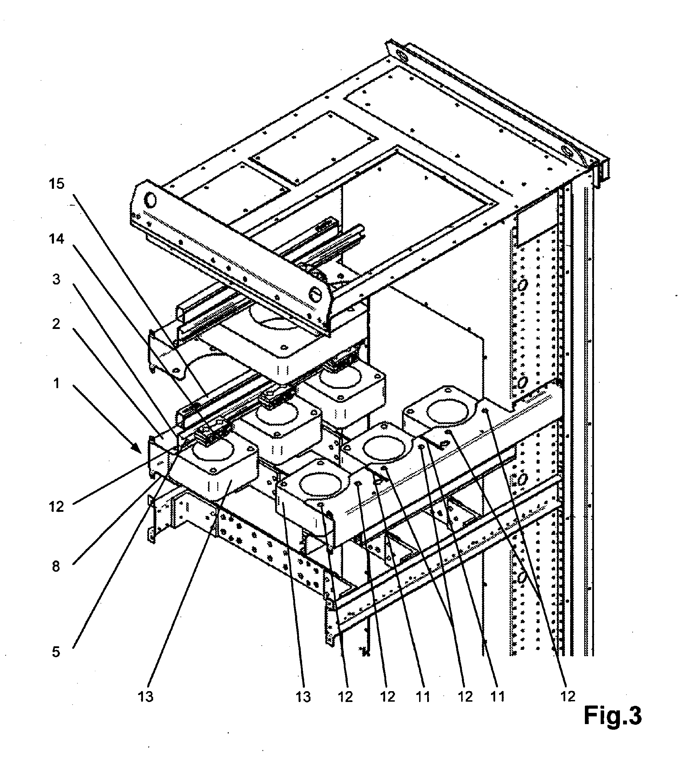

In Fig. 1 ist eine Ausführungsform einer erfindungsgemässen Fixiereinrichtung für einen Stromsensor in einer Vorderansicht dargestellt. Die Fixiereinrichtung umfasst darin ein nach Art eines U geformtes Aufnahmeelement 1 und ein mit dem freien Ende eines Schenkels 2 des Aufnahmeelementes 1 verbundenes Flächenteil 3, wobei das Flächenteil 3 im wesentlichen senkrecht zum verbundenen Schenkel 2 angeordnet ist und sich von der Öffnung 4 des Aufnahmeelementes 1 weg erstreckt. Weiterhin umfasst die Fixiereinrichtung gemäss Fig. 1 ein mit dem Flächenteil 3 verbundenes und nach Art eines C geformtes Halteelement 5, wobei die Ausrichtung der Öffnung 6 des Halteelementes 5 im wesentlichen der Ausrichtung der Öffnung 4 des Aufnahmeelementes 1 entspricht, d.h. die Öffnung 6 des Halteelementes 5 zeigt im wesentliche in dieselbe Richtung wie die Öffnung 4 des Aufnahmeelementes 1. In Fig. 2 ist die Ausführungsform der erfindungsgemässen Fixiereinrichtung nach Fig. 1 in einer räumlichen Ansicht gezeigt, wobei das c-förmige Halteelement 5 der Übersichtlichkeit wegen in Fig. 2 nicht dargestellt ist. Weiterhin ist in Fig. 3 ein Schaltschrankeinbau der erfindungsgemässen Fixiereinrichtung dargestellt. Durch die Fixiereinrichtung lässt sich der Stromsensor 13 mit Vorteil sehr einfach zwischen die beiden Schenkel 2, 8 des u-förmigen Aufnahmeelementes 1 einbringen und danach beispielsweise durch Verschraubung fixieren. Dadurch ist eine vorteilhafte Vormontage des Stromsensors 13 oder mehrerer Stromsensoren 13 an der Fixiereinrichtung ausserhalb des endgültigen Einbaus und somit beispielsweise ausserhalb von typischerweise beengten Platzverhältnissen innerhalb eines Schaltschrankes möglich. Nach der Vormontage muss die Fixiereinrichtung lediglich endmontiert werden, beispielsweise in besagtem Schaltschrank, wie in Fig. 3 gezeigt. In das mit dem Flächenteil 3 verbundene c-förmige Halteelement 5 kann mit Vorteil eine Kabelhalteeinrichtung 14, insbesondere seitlich und nicht an der Öffnung 6 des Halteelementes 5, eingeschoben und beispielsweise sehr einfach an der Basis des c-förmigen Halteelementes 5 durch Klemmung mittels einer Verschraubung fixiert werden. Kabel mit den mittels der oder den Stromsensoren 13 zu messenden Strömen sind dann lediglich noch an der Kabelhalteeinrichtung 14 zu befestigen und zu dem oder zu den dann nahe gelegenen Stromsensoren 13 zu führen, durch welchen der oder die besagten Ströme dann gemessen werden können. Insgesamt kann die Montage des bzw. der Stromsensoren 13 mittels der Fixiereinrichtung vereinfacht werden, da eine Vielzahl von einzelnen Fixierungen und damit aufwendigen Arbeiten entfällt. Die Montage kann somit schneller und mit einer geringeren Fehleranfälligkeit ausgeführt werden.

Vorzugsweise bildet das Aufnahmeelement 1 mit dem Flächenteil 3 ein Stück. Die Herstellung des Aufnahmeelementes 1 mit dem Flächenteil 3 ist damit beispielsweise durch entsprechende Biegung aus einer einzigen Platte sehr einfach möglich. Weitere Herstellungsverfahren wie Tiefziehen in Verbindung mit Biegen einer einzigen Platte oder Aneinanderfügen und verkleben, verschweissen oder verlöten einzelner Plattenteile zur Erzielung der Einstückigkeit des Aufnahmeelementes 1 mit dem Flächenteil 3 sind ebenfalls denkbar. Weiterhin ist es denkbar, dass das Flächenteil 3 mit dem Halteelement 5 ein Stück bildet, wobei dann das Halteelement 5 beispielsweise an das Flächenteil 3 gefügt und zur Erzielung der Einstückigkeit des Flächenteils 3 mit dem Halteelement 5 verklebt, verschweisst, verlötet oder verschraubt wird. Die Realisierung der Fixiereinrichtung ist damit sehr einfach.

Gemäss Fig. 1 ist das freie Ende des einen Schenkels 2 des Aufnahmeelementes 1 über eine Verbindungsfläche 7 mit dem Flächenteil 3 verbunden. Vorzugsweise ist die Verbindungsfläche 7 als plane Fläche, wie in Fig. 1 gezeigt, ausgebildet. Mittels der Verbindungsfläche lassen sich hohe elektrische Felder im Bereich "freies Ende des einen Schenkels 2 des Aufnahmeelementes - Flächenteil 3", welche in diesem Bereich aufgrund von Spitzen und Ecken auftreten können, vorteilhaft vermeiden. Das Risiko von Teilentladungen in besagtem Bereich ist somit gering. Eine weitere Reduzierung hoher elektrischer Felder und damit eine weitere Verringerung des Teilentladungsrisikos im Bereich "freies Ende des einen Schenkels 2 des Aufnahmeelementes - Flächenteil 3" kann dadurch erreicht, dass die Verbindungsfläche 7 als gekrümmte Fläche, d.h. gebogene Fläche ausgebildet ist. Vorzugsweise bildet das Aufnahmeelement 1 mit der Verbindungsfläche 7 und mit dem Flächenteil 3 ein Stück, wobei sich die bereits vorstehend genannten Herstellungsmöglichkeiten zur Erzielung der Einstückigkeit und die damit verbundenen Vorteile ergeben.

Gemäss Fig. 2 weist die Verbindungsfläche 7 mindestens eine Durchführung 10 auf, durch welche Messkabel des Stromsensors 13 vorteilhaft geführt und in einen Kabelkanal 15, wie beispielhaft in Fig. 3 gezeigt, gelegt und weitergeführt werden können. Eine derzeit gängige separate Messkabelführung und Messkabelbefestigung beispielsweise innerhalb eines Schaltschrankes vereinfacht sich dadurch stark oder entfällt ganz, wodurch sich die Montage insgesamt vereinfacht.

Gemäss Fig. 2 ist an dem Schenkel 8 des Aufnahmeelementes 1 ohne das verbundene Flächenteil 3 ein Schlitz 11 vorgesehen, welcher Schlitz 11 sich von dem freien Ende des einen Schenkels 8 des Aufnahmeelementes 1 in Richtung Basis 9 des Aufnahmeelementes 1 erstreckt. Der Schlitz 11 entkoppelt beispielsweise zwei zwischen den Schenkeln 2, 8 des u-förmigen Aufnahmeelementes 1 fixierte Stromsensoren 13 mechanisch, so das beispielsweise jeder separat Stromsensor 13 zwischen die Schenkel 2, 8 des Aufnahmeelementes 1 eingebracht und anschliessend zum Beispiel mittels Verschraubung fixiert werden kann bevor der nächste Stromsensor 13 eingebracht und fixiert wird. Bei einem Austausch eines Stromsensors 13 infolge beispielsweise eines Defektes hat der Schlitz 11 ebenfalls den Vorteil der mechanischen Entkopplung dahingehend, dass lediglich der defekte Stromsensor 13 von seiner Fixierung gelöst und herausgenommen werden muss, während der andere Stromsensor 13 verbleiben kann. Vorzugsweise sind im Falle mehrerer Schlitze 11 die Schlitze 11 parallel zueinander und äquidistant an dem Schenkel 8 des Aufnahmeelementes 1 ohne das verbundene Flächenteil 3 angeordnet. Die Anordnung mehrerer Stromsensoren 13 im Falle mehrerer Schlitze 11 ist in Fig. 3 dargestellt.

Gemäss Fig. 2 und Fig. 3 weist jeder Schenkel 2, 8 des Aufnahmeelementes 1 im Bereich des freien Endes des jeweiligen Schenkels 2, 8 mindestens ein durchgehendes Loch 12 auf. Vorzugsweise ist jeweils ein durchgehendes Loch 12 des einen Schenkels 2, 8 fluchtend zu jeweils einem durchgehenden Loch 12 des anderen Schenkels 2, 8 angeordnet. Durch die jeweils zwei zueinander fluchtend angeordneten Löcher 12 der Schenkel 2, 8 kann, nachdem der Stromsensor 13 zwischen die Schenkel 2, 8 des Aufnahmeelementes 1 eingebracht ist, eingeführt werden. Durch Festziehen der Schraube werden dann die Schenkel 2, 8 des Aufnahmeelementes 1 gegeneinander gezogen und pressen gegen den Stromsensor 13 zu dessen Fixierung. Eine weitere Möglichkeit der Fixierung des Stromsensors 13 besteht dann, falls der Stromsensor 13 selbst mindestens ein durchgehendes Loch aufweist. Die Schraube kann dann mit Vorteil zuerst durch das durchgehende Loch 12 des einen Schenkels 2, 8, dann durch das durchgehenden Loch des Stromsensors 13 und anschliessend durch das durchgehende Loch des anderen Schenkels 2, 8 geführt und dann festgezogen werden, wodurch eine verbesserte Fixierung des Stromsensors 13 erreicht werden kann und zudem ein ungewolltes Herausrutschen des Stromsensors 13 aus den beiden Schenkel 2, 8, selbst bei gelockerter Schraube, verhindert werden kann.

Vorstehend beschrieben wurde eine Fixiereinrichtung für einen Stromsensor 13. Es sei aber ausdrücklich erwähnt, dass die Verwendung der Fixiereinrichtung nicht auf einen Stromsensor 13 beschränkt ist, sondern für jegliche elektronische Bauelemente verwendet werden kann.

### Bezugszeichenliste

- 1: Aufnahmeelement
- 2: Schenkel des Aufnahmeelementes mit verbundenem Flächenteil
- 3: Flächenteil
- 4: Öffnung des Aufnahmeelementes
- 5: Halteelement
- 6: Öffnung des Halteelementes
- 7: Verbindungsfläche
- 8: Schenkel des Aufnahmeelementes ohne verbundenem Flächenteil
- 9: Basis des Aufnahmeelementes
- 10: Durchführung
- 11: Schlitz
- 12: durchgehendes Loch
- 13: Stromsensor
- 14: Kabelhalteeinrichtung
- 15: Kabelkanal

## Patentansprüche

1. Fixiereinrichtung für einen Stromsensor (13), umfassend
ein nach Art eines U geformtes und der Aufnahme des Stromsensors (13) dienendes Aufnahmeelement (1),
ein mit dem freien Ende eines Schenkels (2) des Aufnahmeelementes (1) verbundenes Flächenteil (3), wobei das Flächenteil (3) im wesentlichen senkrecht zum verbundenen Schenkel (2) angeordnet ist und sich von der Öffnung (4) des Aufnahmeelementes (1) weg erstreckt, und
ein mit dem Flächenteil (3) verbundenes, nach Art eines C geformtes und der Aufnahme einer Kabelhalteeinrichtung (14) dienendes Halteelement (5), wobei die Ausrichtung der Öffnung (6) des Halteelementes (5) im wesentlichen der Ausrichtung der Öffnung (4) des Aufnahmeelementes (1) entspricht.

2. Fixiereinrichtung nach Anspruch 1, **dadurch gekennzeichnet, dass** das Flächenteil (3) mit dem Halteelement (5) ein Stück bildet.

3. Fixiereinrichtung nach einem der Ansprüche 1 oder 2, **dadurch gekennzeichnet, dass** das Aufnahmeelement (1) mit dem Flächenteil (3) ein Stück bildet.

4. Fixiereinrichtung nach einem der Ansprüche 1 oder 2, **dadurch gekennzeichnet, dass** das freie Ende des einen Schenkels (2) des Aufnahmeelementes (1) über eine Verbindungsfläche (7) mit dem Flächenteil (3) verbunden ist.

5. Fixiereinrichtung nach Anspruch 4, **dadurch gekennzeichnet, dass** die Verbindungsfläche (7) als plane Fläche ausgebildet ist.

6. Fixiereinrichtung nach Anspruch 4, **dadurch gekennzeichnet, dass** die Verbindungsfläche (7) als gekrümmte Fläche ausgebildet ist.

7. Fixiereinrichtung nach Anspruch 4 bis 6, **dadurch gekennzeichnet, dass** das Aufnahmeelement (1) mit der Verbindungsfläche (7) und mit dem Flächenteil (3) ein Stück bildet.

8. Fixiereinrichtung nach einem der Ansprüche 4 bis 7, **dadurch gekennzeichnet, dass** die Verbindungsfläche (7) mindestens eine Durchführung (10) aufweist.

9. Fixiereinrichtung nach einem der Ansprüche 1 bis 8, **dadurch gekennzeichnet, dass** an dem Schenkel (8) des Aufnahmeelementes (1) ohne das verbundene Flächenteil (3) mindestens ein Schlitz (11) vorgesehen ist, welcher Schlitz (11) sich von dem freien Ende des einen Schenkels (8) des Aufnahmeelementes (1) in Richtung Basis (9) des Aufnahmeelementes (1) erstreckt.

10. Fixiereinrichtung nach Anspruch 9, **dadurch gekennzeichnet, dass** im Falle mehrerer Schlitze (11) die Schlitze (11) parallel zueinander und äquidistant an dem Schenkel (8) des Aufnahmeelementes (1) ohne das verbundene Flächenteil (3) angeordnet sind.

11. Fixiereinrichtung nach einem der Ansprüche 1 bis 10, **dadurch gekennzeichnet, dass** jeder Schenkel (2, 8) des Aufnahmeelementes (1) im Bereich des freien Endes des jeweiligen Schenkels (2, 8) mindestens ein durchgehendes Loch (12) aufweist.

12. Fixiereinrichtung nach Anspruch 11, **dadurch gekennzeichnet, dass** jeweils ein durchgehendes Loch (12) des einen Schenkels (2, 8) fluchtend zu jeweils einem durchgehenden Loch (12) des anderen Schenkels (2, 8) angeordnet ist.

## Claims

1. Fixing device for a current sensor (13), comprising
a holding element (1) which is shaped in the manner of a U and serves to hold the current sensor (13),
a surface part (3) which is connected to the free end of a limb (2) of the holding element (1), with the surface part (3) being arranged substantially perpendicular to the connected limb (2) and extending away from the opening (4) in the holding element (1), and
a retaining element (5) which is connected to the surface part (3) and is shaped in the manner of a C and serves to hold a cable retaining device (14), with the orientation of the opening (6) in the retaining element (5) corresponding substantially to the orientation of the opening (4) in the holding element (1).

2. Fixing device according to Claim 1, **characterized in that** the surface part (3) is integral with the retaining element (5).

3. Fixing device according to either of Claims 1 and 2, **characterized in that** the holding element (1) is integral with the surface part (3).

4. Fixing device according to either of Claims 1 and 2, **characterized in that** the free end of one of the limbs (2) of the holding element (1) is connected to the surface part (3) by means of a connection surface (7).

5. Fixing device according to Claim 4, **characterized in that** the connection surface (7) is in the form of a planar surface.

6. Fixing device according to Claim 4, **characterized in that** the connection surface (7) is in the form of a curved surface.

7. Fixing device according to Claims 4 to 6, **characterized in that** the holding element (1) is integral with the connection surface (7) and with the surface part (3).

8. Fixing device according to one of Claims 4 to 7, **characterized in that** the connection surface (7) has at least one leadthrough (10).

9. Fixing device according to one of Claims 1 to 8, **characterized in that** at least one slot (11) is provided on the limb (8) of the holding element (1) without the connected surface part (3), said slot (11) extending from the free end of one of the limbs (8) of the holding element (1) in the direction of the base (9) of the holding element (1).

10. Fixing device according to Claim 9, **characterized in that,** when there are a plurality of slots (11), the slots (11) are arranged parallel to one another and equidistant on the limb (8) of the holding element (1) without the connected surface part (3).

11. Fixing device according to one of Claims 1 to 10, **characterized in that** each limb (2, 8) of the holding element (1) has at least one continuous hole (12) in the region of the free end of the respective limb (2, 8).

12. Fixing device according to Claim 11, **characterized in that** in each case one continuous hole (12) in one of the limbs (2, 8) is arranged so as to be aligned with in each case one continuous hole (12) in the other limb (2, 8).

## Revendications

1. Dispositif de fixation pour un capteur de courant (13), comprenant :
un élément de réception (1) en forme de U et servant à recevoir le capteur de courant (13),
une partie de surface (3) connectée à l'extrémité libre d'une branche (2) de l'élément de réception (1), la partie de surface (3) étant disposée essentiellement perpendiculairement à la branche connectée (2), et s'étendant depuis l'ouverture (4) de l'élément de réception (1) à l'opposé de celle-ci, et
un élément de retenue (5) connecté à la partie de surface (3), en forme de C et servant à recevoir un dispositif de retenue de câble (14), l'orientation de l'ouverture (6) de l'élément de retenue (5) correspondant essentiellement à l'orientation de l'ouverture (4) de l'élément de réception.

2. Dispositif de fixation selon la revendication 1, **caractérisé en ce que** la partie de surface (3) est formé d'une pièce avec l'élément de retenue (5).

3. Dispositif de fixation selon l'une quelconque des revendications 1 ou 2, **caractérisé en ce que** l'élément de réception (1) est formé d'une pièce avec la partie de surface (3).

4. Dispositif de fixation selon l'une quelconque des revendications 1 ou 2, **caractérisé en ce que** l'extrémité libre d'une des branches (2) de l'élément de réception (1) est connectée par le biais d'une surface de connexion (7) à la partie de surface (3).

5. Dispositif de fixation selon la revendication 4, **caractérisé en ce que** la surface de connexion (7) est réalisée sous forme de surface plane.

6. Dispositif de fixation selon la revendication 4, **caractérisé en ce que** la surface de connexion (7) est réalisée sous forme de surface courbe.

7. Dispositif de fixation selon l'une quelconque des revendications 4 à 6, **caractérisé en ce que** l'élément de réception (1) est formé d'une pièce avec la surface de connexion (7) et avec la partie de surface (3).

8. Dispositif de fixation selon l'une quelconque des revendications 4 à 7, **caractérisé en ce que** la surface de connexion (7) présente au moins un passage (10).

9. Dispositif de fixation selon l'une quelconque des revendications 1 à 8, **caractérisé en ce que** l'on prévoit au moins une fente (11) sur la branche (8) de l'élément de réception (1) sans la partie de surface connectée (3), ladite fente (11) s'étendant depuis l'extrémité libre de l'une des branches (8) de l'élément de réception (1) dans la direction de la base (9) de l'élément de réception (1).

10. Dispositif de fixation selon la revendication 9, **caractérisé en ce que,** dans le cas de plusieurs fentes (11), les fentes (11) sont disposées parallèlement les unes aux autres et de manière équidistante sur la branche (8) de l'élément de réception (1) sans la partie de surface connectée (3).

11. Dispositif de fixation selon l'une quelconque des revendications 1 à 10, **caractérisé en ce que** chaque branche (2, 8) de l'élément de réception (1) présente au moins un trou traversant (12) dans la région de l'extrémité libre de chaque branche (2, 8).

12. Dispositif de fixation selon la revendication 11, **caractérisé en ce qu'**à chaque fois un trou traversant (12) de l'une des branches (2, 8) est disposé en affleurement avec un trou traversant (12) respectif de l'autre branche (2, 8).
